# EUROPEAN PATENT SPECIFICATION

(11) **EP 1 543 335 B1**
(45) Date of publication and mention of the grant of the patent: **04.10.2006**
(21) Application number: 02807771.7
(22) Date of filing: 18.11.2002
(51) Int. Cl.: G01R 19/155, G01R 19/165

(54) **PASSIVE INDICATOR OF VOLTAGE PRESENCE**
PASSIVER ANZEIGER DER SPANNUNGSPRÄSENZ
INDICATEUR PASSIF DE LA PRESENCE DE TENSION

(30) Priority: 30.08.2002 PL 35579602
(43) Date of publication of application: 22.06.2005
(73) Proprietor: ABB Technology Ltd, 8050 Zürich (CH)
(72) Inventor: CZYZEWSKI, Jan, PL-30-223 Krakow (PL); PIASECKI, Wojciech, PL-30-611 Krakow (PL); STRÜMPLER, Ralf, CH-5412 Gebenstorf (CH); GLATZ-REICHENBACH, Joachim, CH-8274 Tägerwilen (CH)
(74) Representative: ABB Patent Attorneys
(86) International application number: PCT/PL2002/000089
(87) International publication number: WO 2004/023151

(56) References cited:
- FR-A- 2 689 655
- JP-A- 63 021 568
- US-A- 5 274 324

## Description

The subject of the invention is a passive indicator of voltage presence, used to indicate voltage presence in electric conductors, high, medium and low-voltage electrically powered devices, electricity distribution systems and electric power transmission lines, especially those operating under high and medium, alternating current (A.C.) voltage. A clear optical signal, which indicates the presence of electric voltage, is generated in the display element of the indicator of voltage presence when the indicator is placed in an electric field generated by electric voltage present in the examined conductor or equipment component.

From published Japanese patent application No. 61-003069 there is known a display detecting live conductors. That device is intended to detect electric field intensity near live conductors by using the threshold voltage of a liquid crystal display. A known liquid crystal display (LCD) with two electrodes and a liquid crystal element is provided with two additional electrodes, of which one is attached to the front surface of the display, and the other to its back surface, the back surface electrode being the one which is placed on the surface of the object which is tested for the presence of an electric field in its near vicinity. Both electrodes of the display are electrically connected with the additional electrodes so that each additional electrode is connected to a different electrode of the LCD. Owing to the additional electrodes, the potential difference generated by the electric field of the tested object between the two electrodes of the liquid crystal element of the display exceeds the threshold value of the display. Always when the examined object is live, the liquid crystal element properly indicates the presence of voltage, which is observed through the display window.

From published Japanese patent application No. 63 021568 there is a known a high voltage indicating display. The indicator comprises a liquid crystal display element with two transparent electrodes and a current collector in a form of a flat plate positioned on one side of the display element. When the indicator is placed between a conductor under high voltage and a ground potential, its current collector becomes capacitively coupled to the high-voltage conductor while one of the display electrodes becomes capacitively coupled to the ground and a threshold voltage is generated between the two transparent electrodes of a liquid crystal display element allowing for indication of the presence of voltage by that display.

The US patent No. 5 274 324 discloses a hot line indicator, indicating the presence of voltage in an electrical conductor of an AC power distribution system. The indicator includes a housing, a probe, a ground coupling member, a status indicating means, a display circuit means, a pair of electrical test terminals and a test circuit means. The status indicating means is a high-impedance display device and it is electrically coupled to the probe and to the ground coupling member via the display circuit means and to the test terminals via the test circuit means. The indicator is used only in conjunction with a lineman's hot stick. The high-impedance display device of the indicator comprises a liquid crystal display.

Another known device for finding the presence and polarisation of direct current (D.C.) voltage and detecting the presence of A.C. voltage is the device disclosed in the USA patent description No. 4 139 820. The device consists of an electric circuit comprising two electrochromic elements, two connecting terminals, two capacitors, two resistors and two diodes. The first output leads of the diodes are connected with each other and they are connected with the first output leads of each resistor and with the first output leads of the electrochromic elements. The second output leads of the electrochromic elements are electrically connected by means of the corresponding capacitors with the second output leads of the corresponding resistors, with the second output leads of the corresponding diodes and with the connecting terminals. The connecting terminals of the device are connected to the test points of the analysed circuit and, if there is voltage between them, it causes colouring of the electrochromic elements. The presence of a D.C. voltage polarised in one direction is demonstrated by colouring of one electrochromic element, and the presence of D.C. voltage polarised in the opposite direction manifests itself by colouring of the other electrochromic element. Simultaneous colouring of both elements indicates the presence of A.C. voltage. With voltage decay between the connecting terminals of the device, the electrochromic element(s) discolour(s).

The presented solutions employ a liquid crystal or an electrochromic electrooptical element as the display element. The characteristic feature of those elements is that their optical properties change distinctly after they are placed in an electric field or after they are connected to electric voltage. The change manifests itself in changing the colour or colour intensity of those elements, changing the characteristics of reflection, refraction, diffusion or polarisation of light by the elements. Known electrochromic displays are used in practice as devices indicating the presence of voltage in various batteries. An example of such solution is presented in US patent description No. 5 737 114.

Besides the displays using liquid crystal or electrochromic electrooptical elements there are also known the electrophoretic displays. For example, from US patent description No. 6 120 588 there is known an electrophoretic display, which comprises a top transparent electrode, a bottom electrode and microcapsules containing positively charged particles of one colour and negatively charged particles of another colour. The application of voltage to the electrodes, depending on the polarisation of the applied voltage, causes that the particles of a specific colour move to the surface of the microcapsule, which results in a noticeable colour change of the display.

The practical use of electrophoretic displays as battery charging indicators is known. For instance, from US patent description No. 6 118 426 there is known a battery indicator comprising an electrophoretic display, the first and the second electrode adherent to the display, a non-linear electrical element, preferably comprising a diode, conducting the battery voltage to the first electrode when the battery voltage exceeds a predefined threshold value, a voltage divider electrically connected to the battery and to the second electrode, and a resistor connected with the non-linear electrical element. Voltage from the battery, supplied by the non-linear electrical element to the first electrode, in conjunction with voltage from the battery passing through the voltage divider, is supplied to the second electrode and generates the electric field sufficient to activate the display. When the voltage drops below the threshold value, the potential from the first electrode is carried away through the resistor, which results in a change in the polarisation of the electric field in the display and a change in its appearance.

It is an object of the invention to provide a passive indicator of voltage presence having a form of a multilayer plate comprising two electrically conductive layers and an intermediate layer of a structure showing electrooptical properties, located between them, wherein the intermediate layer is a display element of the indicator, and the conductive layers are electrodes of the display element, and they are electrically connected with each other by means of a diode, and between the intermediate layer and one of the conductive layers there is located a dielectric layer, which is separated from the intermediate layer by an additional electrically conductive layer, and one of the conductive layers is at least partially transparent.

In one variant of the invention, the intermediate layer of the indicator is preferably an electrophoretic structure.

In the second variant of the invention, the intermediate layer of the indicator can also be a liquid-crystal based electrooptical structure.

In the third variant of the invention, the intermediate layer of the indicator can also be an electrochromic structure.

It is a further object of the invention, to provide a passive indicator of voltage presence having a form of a multilayer plate comprising two electrically conductive layers and an intermediate layer of a structure showing electrooptical properties, located between them, wherein the intermediate layer is a display element of the indicator, and the conductive layers are electrodes of the display element and at least one of the electrically conductive layers is divided into smaller conductive surfaces, separated from each other and being not in contact with one another, which adhere to the intermediate layer and are electrically connected with the other electrically conductive layer, or with the individual conductive surfaces that other electrically conductive layer is divided into, by means of diodes whose electrodes are oriented in opposite directions with respect to the connected electrically conductive layers or their conductive surfaces, and at least one of the conductive surfaces is at least partially transparent.

Preferably, the intermediate layer of the indicator in this variant of the invention is an electrophoretic structure.

The intermediate layer of the indicator in this variant of the invention can also be an electrochromic structure.

The advantage of the passive voltage indicator according to the invention is its simple structure. The voltage indicator does not require neither its own power source nor a galvanic connection to the source of the tested voltage. Indication is based only on the sensitivity to the electric field present in the direct vicinity of conductors and equipment under voltage, and its reading can be taken by unaided eye from a safe distance. This allows the person taking the reading to avoid contact with such conductors or equipment. It also allows to eliminate insulation elements in the indicator structure. The use of a diode or diodes causes that the indicator's sensitivity to the D.C. component of an electric field can be much lower than its sensitivity to the A.C. component of that field, which makes the indicator readings independent from static charges, which often collect on the surface of live medium and high voltage conductors and equipment, and is very useful when the indicator is applied to power equipment operating under A.C. voltage.

The subject of the invention is presented in the drawings, in which fig. 1 shows the variant of the passive indicator in axonometric projection, figs.: 1a, 3a, 1b - a fragment of the intermediate layer of the indicator in various versions fig. 2 - another known variant of the indicator, with the dielectric layer, in cross-section, fig. 3 - the first embodiment of the indicator with the additional conductive layer, in cross-section, fig. 4 to fig. 6 -variants of the second embodiment of the indicator in axonometric projection, wherein the non-transparent conductive layer, the transparent layer or both conductive layers are divided into smaller conductive surfaces, and fig. 7 - an example of a practical application of the indicator.

The passive indicator of voltage presence is a flexible, multilayer plate 1, consisting of a transparent, electrically conductive layer 2, an intermediate layer 3 of the indicator, adhering to the conductive layer 2, and another, non-transparent conductive layer 4 adhering to the intermediate layer 3 on its opposite side. The intermediate layer 3 contains a material or a structure manifesting electrooptical properties, which cause a change in the optical properties of that material or structure when it is placed in an electric field whose forces are oriented perpendicularly to the surface of that layer. The conductive layers 2 and 4 are the indicator electrodes, between which there is placed the display element of the indicator having a form of the intermediate layer 3. The conductive layers 2 and 4 are connected with each other by means of a diode 5. One terminal of the diode 5, being its cathode output 6, is electrically connected with the transparent conductive layer 2. The other terminal of the diode 5, being its anode input 7, is connected with the non-transparent conductive layer 4. In another case, not shown in the drawing, the conductive layers 2 and 4 can be connected with one another by means of the diode 5 in such a way that one terminal of the diode 5, being its anode input 7, is electrically connected with the transparent conductive layer 2, and the second terminal of the diode 5, being its cathode output 6, is connected with the non-transparent conductive layer 4.

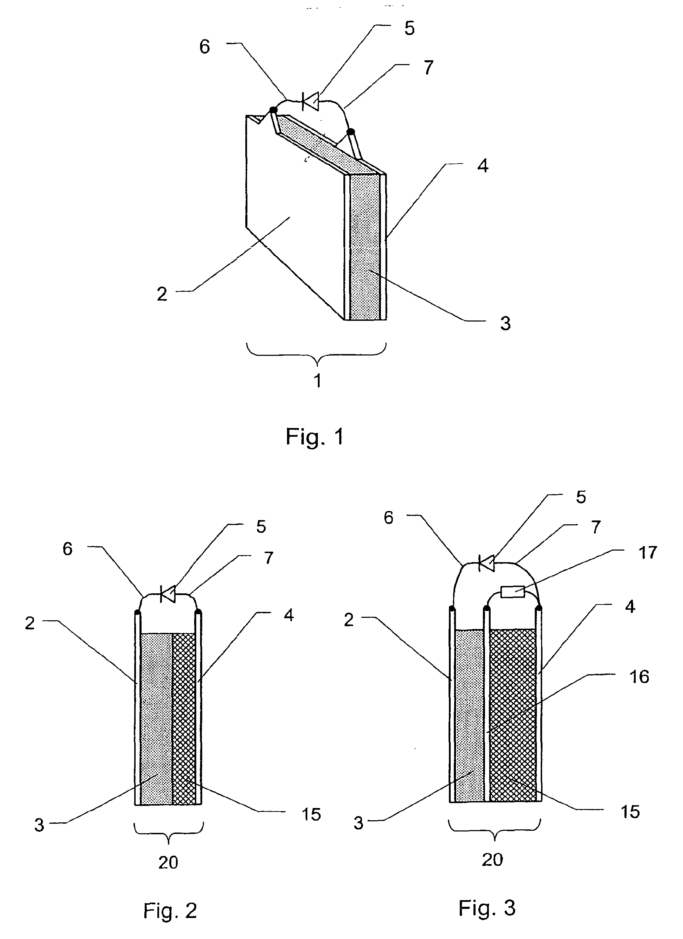

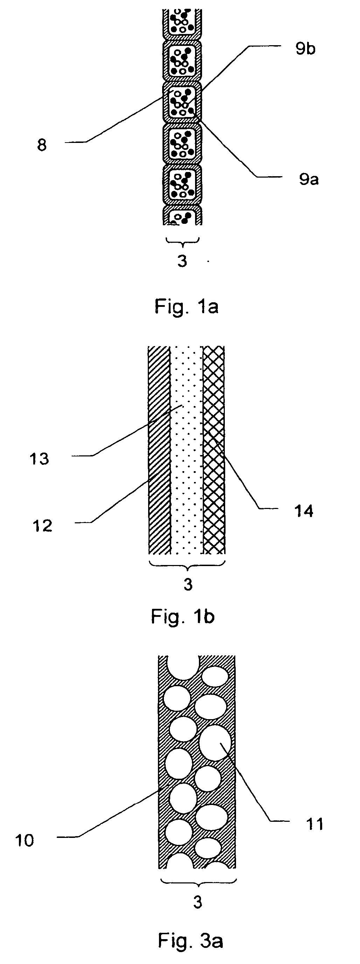

The intermediate layer 3 in the preferable embodiment of the indicator, as presented in fig. 1a, is an electrophoretic structure, which contains electrophoretic capsules 8 filled with a dielectric fluid containing positively charged particles 9a and negatively charged particles 9b. In experimental conditions of the invention application, when the indicator was placed in an A.C. electric field of averaged amplitude of 1 kV/cm and frequency of 50 Hz, visible changes in the colour of the display were obtained not later than 1 second after the placement. Depending on the polarisation of the diode, the display colour changes to black or white. Placement of the indicator in a D.C. electric field of a similar amplitude does not result in visible changes in the colour of the display, no matter what the polarisation of the field is. In the experimental embodiment of the invention the electrochromic structure Ink-In-Motion^{™} manufactured by E INK Corporation was used together with a typical semiconductor diode of the type 1N4148.

In another indicator, depicted in fig. 1b, the intermediate layer 3 is an electrochromic structure. Such structure consists of an electrochromic layer 12 containing an electrochromic compound, electrolyte 13 in liquid or solid form and a layer of ion accumulator 14. If electrolyte in liquid form is used, the intermediate layer 3 is a closed vessel. In the experimental embodiment of the indicator according to the invention the electrochromic layer 14 can be made of tungstic trioxide WO₃, the ion accumulator layer 14 can be made of iridium oxide IrOₓ, and the electrolyte 13 can be a solution of lithium perchlorate LiClO₄ in propylene carbonate (PC).

In another variant of the indicator, which is presented in fig. 2, there is a flexible dielectric layer 15, placed between the intermediate layer 3 and the conductive layer 4. The function of that layer is to reduce the electric capacitance and to increase the imaginary part of the impedance between the conductive layers 2 and 4, which causes an increase of the voltage generated between those electrodes by the tested electric field, and thus an increase in the indicator sensitivity. In order to decrease the real part of the impedance of the layer 15 and to increase the D.C. voltage component generated in the intermediate layer 3, the layer 15 can also be made of dielectric material of weak electric conductivity, for instance, of carbon-black doped polymer. Alternatively, the dielectric layer 15 can be placed between the intermediate layer 3 and the conductive layer 2, which is not shown in the drawing. In both cases, the conductive layers 2 and 4 are connected with one another by means of the diode 5 as in the earlier described embodiments. In this variant embodiment of the invention the intermediate layer 3 is one of the electrooptical structures shown in fig. 1a and 1b.

In the first embodiment of the invention, presented in fig. 3, between the intermediate layer 3 and the conductive layer 4 there is placed the flexible dielectric layer 15, which is separated from the intermediate layer 3 by means of a flexible additional conductive layer 16. The purpose of the additional conductive layer 16 is to allow for the connection of additional resistance or capacitance elements parallel to the intermediate layer 3 or parallel to the dielectric layer 15. The purpose of the resistance or capacitance elements is the adjustment of the real and imaginary parts of the impedance over those layers, which provides the appropriate division of the D.C. and A.C. voltage components between the layers. In the examplary embodiment of the invention the conductive layer 16 is electrically connected with the conductive layer 4 by means of a resistance element 17. The resistance element, when connected in that way, also reduces the indicator response time after the disconnection of the electric field, when an electrochromic layer, such as the one from fig. 1c, is used as the intermediate layer 3. The dielectric layer 15 can be placed between the intermediate layer 3 and the conductive layer 2, which is not shown in the drawing. In both cases the conductive layers 2 and 4 are connected with each other by means of the diode 5 as in the embodiments described earlier. In this variant embodiment of the invention the intermediate layer 3 is one of the electrooptical structures identical with those shown in fig. 1a, 3a and 1b.

The intermediate layer 3, shown in fig. 3a, is a liquid-crystal based structure comprising liquid crystal droplets 11 contained in the pores of a polymer binding material 10. Such structures are known as polymer dispersed liquid crystal structures, abbreviated to PDLC. To build the exemplary embodiment of the invention in experimental conditions, a Polyvision^{™} membrane produced by Polytronix incorporated can be used. In the exemplary embodiment of the invention shown in fig. 1, using the PDLC structure in the experimental embodiment of the indicator according to the invention, the conductive layer 4 is provided with a printed pattern, not shown in the drawing, on the side neighbouring the intermediate layer 3, and the conductive layer 2 is transparent across its whole surface. When the indicator is placed in an electric field of a value exceeding the threshold value, the intermediate layer 3 becomes transparent and shows the pattern printed on the conductive layer 4. When the electric field is switched off, the intermediate layer of indicator 3 returns to the light-diffusing state and the surface of the indicator becomes homogenous. The intermediate layer 3 can also be another electrooptical structure, for instance one of known structures based on nematic or ferroelectric liquid crystals.

In other variant embodiments of the invention, not shown in the drawing, the dielectric layer 15 consists of several dielectric layers, adherent to each other, made of different materials.

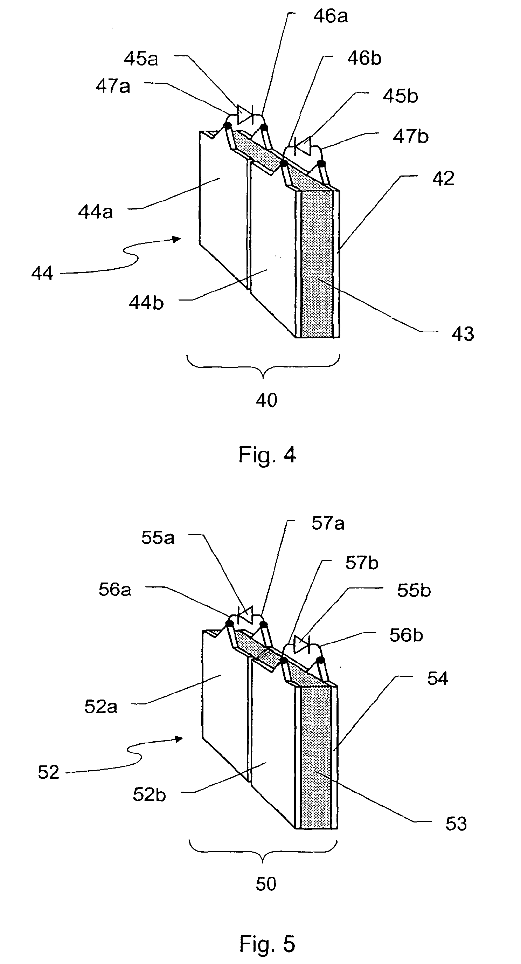

In a variant of the second embodiment of the invention, shown in fig. 4, the passive indicator of voltage presence is a flexible, multilayer plate 40, consisting of a transparent, electrically conductive layer 42, an intermediate layer 43 of the indicator, adherent to the conductive layer 42, and another, non-transparent conductive layer 44, adhering to the intermediate layer 43 on its opposite side, which layer 44 is divided into smaller conductive surfaces 44a and 44b, separated from each other and being not in contact with one another. Those conductive surfaces are attached to the intermediate layer 43. The intermediate layer 43 contains a material or a structure showing electrooptical properties, which cause that the optical properties of that material or structure change when it is placed in an electric field whose forces are oriented perpendicularly to the surface of that layer. The conductive layers 42 an 44 are the indicator electrodes, between which the indicator display element having a form of the intermediate layer 43 is placed. In the indicator according to this variant embodiment of the invention, the conductive layer 42 and the conductive surface 44a are connected with each other by means of a diode 45a, while the conductive layer 42 and the conductive layer 44b are connected with one another by means of a diode 45b. One terminal of the diode 45a, which is its cathode output 46a, is electrically connected with the transparent conductive layer 42. The second terminal of the diode 45a, which is its anode input 47a, is connected with the non-transparent conductive layer 44a. One terminal of the diode 45b, which is its anode input 47b, is electrically connected with the transparent conductive layer 42. The other terminal of the diode 45b, which is its cathode output 46b, is connected with the non-transparent conductive surface 44b. In this variant embodiment of the invention the intermediate layer 43 is one of the electrooptical structures, identical with those shown in fig. 1a and 1c.

In another variant of the second embodiment of the invention, shown in fig. 5, the passive indicator of voltage presence is a flexible, multilayer plate 50, consisting of a transparent electrically conductive layer 52, which is divided into smaller conductive surfaces 52a and 52b, separated from one another and not in contact with each other. Those surfaces are attached to an intermediate layer 53. To the opposite side of the intermediate layer 53 of the indicator there adheres another, non-transparent conductive layer 54. The intermediate layer 53 contains a material or a structure showing electrooptical properties that cause a change of the optical properties of that material or structure when it is placed in an electric field whose forces are oriented perpendicularly to the surface of that layer. The conductive layers 52 and 54 are the indicator electrodes, between which there is placed the indicator display element having a form of the intermediate layer 53. In the indicator according to this variant embodiment of the invention, the transparent conductive surface 52a and the non-transparent conductive surface 54 are connected with each other by means of a diode 55a, while the transparent conductive surface 52b and the non-transparent conductive layer 54 are connected with one another by means of a diode 55b. One terminal of the diode 55a, which is its cathode output 56a, is electrically connected with the transparent conductive surface 52a. The other terminal of the diode 55a, which is its anode input 57a, is connected with the non-transparent conductive surface 54. One terminal of the diode 55b, which is its anode input 57b, is electrically connected with the transparent conductive surface 52b. The other terminal of the diode 55b, which is its cathode output 56b, is connected with the non-transparent conductive layer 54. In this variant embodiment of the invention the intermediate layer 53 is one of the electrooptical structures, identical with those shown in fig. 1a and 1c.

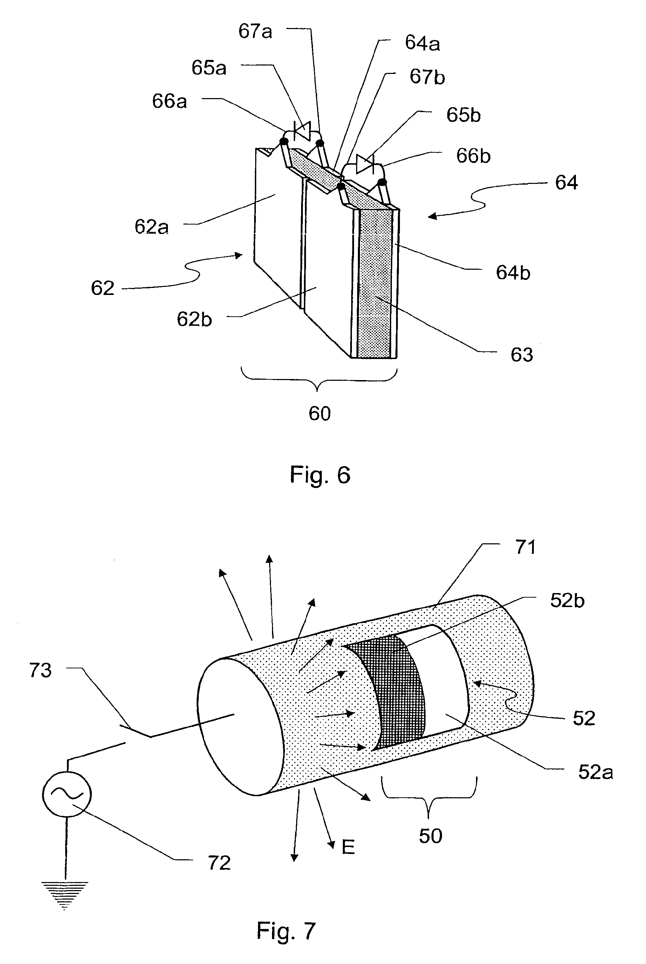

In the next variant of the second embodiment of the invention, presented in fig. 6, the passive indicator of voltage presence is a flexible, multilayer plate 60, consisting of a transparent, electrically conductive layer 62, which is divided into smaller conductive surfaces 62a and 62b, separated from each other and not in contact with each other. Those surfaces are attached to the intermediate layer 63. To the opposite side of the intermediate layer 63 of the indicator, there adheres another, non-transparent conductive layer 64, which is divided into smaller conductive surfaces 64a and 64b, separated from one another and having no contact with one another. Those surfaces are attached to the intermediate layer 63. The intermediate layer 63 contains a material or a structure that shows electrooptical properties which cause a change of the optical properties of that material or structure when it is placed in an electric field whose forces are oriented perpendicularly to the surface of that layer. The conductive layers 62 and 64 are the indicator electrodes, between which the indicator display element is placed, having a form of the intermediate layer 63. In the embodiment of the indicator according to this variant of the invention, the transparent conductive surface 62a and the non-transparent conductive surface 64a are connected with one another by means of a diode 65a, while the transparent conductive surface 62b and the non-transparent conductive surface 64b are connected with one another by means of a diode 65b. One terminal of the diode 65a, which is its cathode output 66a, is electrically connected with the transparent conductive surface 62a. The other terminal of the diode 65a, which is its anode input 67a, is connected with the non-transparent conductive surface 64a. Furthermore, one terminal of the diode 65b, being its anode input 67b, is electrically connected with the transparent conductive surface 62b. The other terminal of the diode 65b, being its cathode output 66b, is connected with the non-transparent conductive surface 64b. As previously, in this variant embodiment of the invention the intermediate layer 63 is formed by electrooptical structures, identical with the structures shown in fig. 1a and 1c.

The various variants of embodiment of the invention, shown in the drawings, do not exhaust all the possible embodiments. The description does not present such embodiment example wherein the intermediate layer 3, 43, 53, 63 is divided into smaller fields separated from one another and attached to one of the conductive layers or to the dielectric layer. In such case, the non-transparent conductive layer or the transparent conductive layer, or both conductive layers at the same time can be divided into smaller surfaces. A similar division of the intermediate layer can be applied in case a dielectric layer between the intermediate layer and one of the conductive layers is used, and if an intermediate conductive layer is used. The latter layers can also be divided into smaller surfaces. The number of possible embodiments increases considerably if the conductive layers, the intermediate layer, the dielectric layer, or the intermediate conductive layer is divided into more than two surfaces or two fields. However, in each of such cases, the individual electrodes of the indicator, located on both sides of the intermediate layer, are interconnected by means of diodes. In addition, the individual electrodes of the indicator, located in the same layer on one side of the intermediate layer or located on both sides of the intermediate layer, can be electrically coupled with one another by means of various types of resistance or capacitance elements. The use of additional connections between individual electrodes allows for the adjustment of the sensitivity and the response times of the device.

In all variants of embodiment of the invention, the transparent conductive layers can be made in the form of a layer of tin-oxide doped indium oxide (ITO) deposited on polyester substrate. The conductive layers, which are not required to be transparent, can be produced by deposition of a metallic, graphite or electrically conductive polymer layer.

In the example of practical realisation of the invention presented in fig. 7, the placement of the indicator, according to the preferable embodiment of the invention shown in fig.5, in an A.C. electric field E, oriented perpendicularly to the surface of the layer plate 50 of the indicator, generated by A.C. voltage 72 supplied by means of a switched-on breaker switch 73 to the device 71, schematically shown in the form of a wire, causes changes in the optical properties of the intermediate layer 53, which is an electrophoretic structure, shown in fig.1a. The changes manifest themselves, for example, in the darkening or brightening of the intermediate layer colour, which can easily be seen by an unaided eye through the transparent conductive surfaces 52a and 52b.

In particular, generation of the A.C. electric field E exceeding a given threshold value, causes the formation of positive potential on the conductive surface 52a with respect to the potential of the conductive layer 54 and the formation of negative potential on the conductive surface 52b with respect to the potential of the conductive layer 54. This causes electrophoretic migration of positively charged particles 9a towards the transparent conductive surface 52b, so that their colour becomes visible through that surface, and similarly, migration of negatively charged particles 9b towards the transparent conductive surface 52a, whose colour, colour saturation or brightness, different from the colour of the particles 9a, becomes visible through that conductive surface. As a result, a contrast between the surfaces 52a and 52b appears, which is visible by unaided eye and which signals the presence of voltage in the device 71. The surfaces, into which the conductive layer 52 is divided, can also have a different shape than that shown in the drawing, for instance in the form of a pattern or inscription, which will cause the appearance of a contrasting pattern or inscription of that shape when voltage is connected to the device 71.

## Claims

1. A passive indicator of voltage presence, in the form of a multilayer plate comprising two electrically conductive layers (2 and 4) and located between them an intermediate layer (3) of a structure showing electrooptical properties, which is a display element of the indicator and the electrically conductive layers are electrodes of the display element, the electrically conductive layers (2 and 4) are electrically connected with each other by means of a diode (5) and one of the conductive layers(2 or 4) is at least partially transparent, **characterized in that** between the intermediate layer (3) and one of the conductive layers (2 and 4) there is located a dielectric layer (15), which is separated from the intermediate layer (3) by an additional electrically conductive layer (16).

2. Passive indicator according to claim 1, **characterized in that** the intermediate layer (3) of the indicator is an electrophoretic structure.

3. Passive indicator according to claim 1, **characterized in that** the intermediate layer (3) of the indicator is a liquid-crystal based electrooptical structure.

4. Passive indicator according to claim 1, **characterized in that** the intermediate layer (3) of the indicator is an electrochromic structure.

5. A passive indicator of voltage presence, in the form of a multilayer plate comprising two electrically conductive layers (42, 44 or 53,54 or 62,64) and located between them an intermediate layer (43 or 53 or 63) of a structure showing electrooptical properties, which is a display element of the indicator and the electrically conductive layers are electrodes of the display element and at least one of the electrically conductive layers (42, 44, 52, 54, 62, 64) is at least partially transparent, **characterized in that** at least one of the electrically conductive layers (42, 44, 52, 54, 62, 64) is divided into smaller conductive surfaces (44a, 44b or 52a, 52b or 62a, 62b) separated from each other and being not in contact with one another, which adhere to the intermediate layer (43 or 53 or 63) and are electrically connected with the other electrically conductive layer (42 or 54) or with the individual conducting surfaces (64a, 64b), that other electrically conductive layer is divided into, by means of diodes (45a, 45b or 55a, 55b or 65a, 65b) whose electrodes are oriented in opposite directions with respect to the connected electrically conductive layers or their conductive surfaces.

6. Passive indicator according to claim 5, **characterized in that** the intermediate layer (43 or 53 or 63) of the indicator is an electrophoretic structure.

7. Passive indicator according to claim 5, **characterized in that** the intermediate layer (43 or 53 or 63) of the indicator is an electrochromic structure.

## Patentansprüche

1. Passiver Spannungsanzeiger in Form eines Mehrschichtplättchens, das zwei stromführende Schichten (2 und 4) besitzt sowie eine zwischen diesen liegende Zwischenschicht (3), die elektrooptische Eigenschaften anzeigt, die ein Anzeigeelement des Spannungsanzeigers bildet, wobei die stromführenden Schichten, die die Elektroden des Anzeigers bilden, mittels einer Diode (5) verbunden sind und eine dieser stromführenden Schichten (2 oder 4) mindestens teilweise durchsichtig ist, **dadurch gekennzeichnet, dass** zwischen der Zwischenschicht (3) und einer der stromführenden Schichten (2 oder 4) eine dielektrische Schicht (15) untergebracht ist, die von der Zwischenschicht (3) mittels einer zusätzlichen stromführenden Schicht (16) abgeteilt ist.

2. Passiver Spannungsanzeiger nach Anspruch 1, **dadurch gekennzeichnet, dass** die Zwischenschicht (3) eine elektrophoretische Struktur ist.

3. Passiver Spannungsanzeiger nach Anspruch 1, **dadurch gekennzeichnet, dass** die Zwischenschicht (3) eine elektrooptische flüssige Kristallstruktur ist.

4. Passiver Spannungsanzeiger nach Anspruch 1, **dadurch gekennzeichnet, dass** die Zwischenschicht (3) eine Elektrochrom-Struktur ist.

5. Passiver Spannungsanzeiger in Form eines Mehrschichtplättchens, das zwei stromführende Schichten (42, 44 oder 53, 54 oder 62, 64) besitzt sowie eine zwischen diesen liegende Zwischenschicht (43 oder 53 oder 63), die elektrooptische Eigenschaften anzeigt, die ein Anzeigeelement des Spannungsanzeigers bildet, wobei die stromführenden Schichten die Elektroden des Anzeigers bilden und mindestens eine der stromführenden Schichten (42, 44, 52, 54, 62, 64) mindestens teilweise durchsichtig ist, **dadurch gekennzeichnet, dass** mindestens eine dieser stromführenden Schichten (42, 44, 52, 54, 62, 64) in kleinere stromführende Flächen (44a, 44b oder 52a, 52b oder 62a, 62b) aufgeteilt ist, die voneinander getrennt sind und keinen gegenseitigen Kontakt haben, die an die Zwischenschicht (43 oder 53 oder 63) anliegen und mit der anderen stromführenden Schicht (42 oder 54) oder mit den individuell stromführenden Flächen (64a, 64b), in die die zweite stromführende Schicht aufgeteilt ist, mittels Dioden (45a, 45b oder 55a, 55b oder 65a, 65b), deren Elektroden in entgegengesetzten Richtungen im Verhältnis zu den verbundenen stromführenden Schichten oder deren stromführenden Flächen gerichtet sind, elektrisch verbunden sind.

6. Passiver Spannungsanzeiger nach Anspruch 5, **dadurch gekennzeichnet, dass** die Zwischenschicht (43, 53 oder 63) eine elektrophoretische Struktur ist.

7. Passiver Spannungsanzeiger nach Anspruch 5, **dadurch gekennzeichnet, dass** die Zwischenschicht (43, 53 oder 63) eine Elektrochrom-Struktur ist.

## Revendications

1. Indicateur passif de la présence de tension, sous la forme d'une plaque multi-couches composée de deux couches conductrices (2 et 4) et, située entre elles, d'une couche intermédiaire (3) dont la structure présente des propriétés électroptiques, qui constitue l'élément de visualisation du indicateur et les couches conductrices sont les électrodes de l'élément de visualisation, les couches conductrices (2 et 4) sont électriquement connectées l'une avec l'autre au moyen d'une diode (5) et l'une des couches conductrices est au moins partiellement transparente, **caractérisée en ce que** entre la couche intermédiaire (3) et l'une des couches conductrices (2 et 4) est située une couche diélectrique (15), qui est séparée de la couche intermédiaire (3) par une couche conductrice additionnelle (16).

2. Indicateur passif selon la revendication **1, caractérisée en ce que** la couche intermédiaire (3) du témoin est une structure électrophore.

3. Indicateur passif selon la revendication **1, caractérisée en ce que** la couche intermédiaire (3) du témoin est une structure électroptique à cristaux liquides.

4. Indicateur passif selon la revendication 1, **caractérisée en ce que** la couche intermédiaire (3) du témoin est une structure électro-chromique.

5. Indicateur passif de la présence de tension, sous la forme d'une plaque multi-couches composée de deux couches conductrices (42, 44 ou 53, 54 ou 62, 64) et, située entre elles, d'une couche intermédiaire (43 ou 53 ou 63), dont la structure présente des propriétés électroptiques, qui constitue l'élément de visualisation du indicateur, et les couches conductrices sont les électrodes de l'élément de visualisation, et l'une au moins des couches conductrices (42, 44, 52, 54, 62, 64) est au moins partiellement transparente, **caractérisée en ce que** l'une au moins des couches conductrices (42, 44, 52, 54, 62, 64) est divisée en deux surfaces conductrices plus petites (44a, 44b ou 52a, 52b ou 62a, 62b), séparées l'une de l'autre et n'étant pas en contact l'une avec l'autre, qui adhèrent à la couche intermédiaire (43 ou 53 ou 63) et sont connectées électriquement avec les autres couches conductrices (42 ou 54) ou avec les surfaces conductrices particulières (64 et 64b) formées par la division des autres couches conductrices, ces connections étant réalisées au moyen de diodes (45a, 45b ou 55a, 55b ou 65a, 65b) dont les électrodes sont orientées dans des directions opposées en accord avec la couche conductrice connectée ou les surfaces conductrices qui la composent.

6. Indicateur passif selon la revendication 5, **caractérisée en ce que** la plaque intermédiaire (43 ou 53 ou 63) du témoin est une structure électrophore.

7. Indicateur passif selon la revendication 5, **caractérisée en ce que** la plaque intermédiaire (43 ou 53 ou 63) du témoin est une structure électro-chromique.
